(19) Europäisches Patentamt / European Patent Office / Office européen des brevets

(11) **EP 2 998 750 B1**

(12) **EUROPÄISCHE PATENTSCHRIFT**

(45) Veröffentlichungstag und Bekanntmachung des Hinweises auf die Patenterteilung:
**13.11.2019 Patentblatt 2019/46**

(51) Int Cl.:
***G01R 31/08*** (2006.01)

(21) Anmeldenummer: **15181913.3**

(22) Anmeldetag: **21.08.2015**

(54) **VERFAHREN UND ANORDNUNG FÜR DIE ERMITTLUNG EINES FEHLERORTES BEI EINEM KURZSCHLUSS ENTLANG EINER ENERGIEVERSORGUNGSSTRECKE MIT MEHREREN LEITERN**

METHOD AND ASSEMBLY FOR DETERMINING AN ERROR LOCATION IN CASE OF A SHORT CIRCUIT ALONG AN ENERGY SUPPLY PATH WITH MULTIPLE CONDUCTORS

PROCEDE ET SYSTEME POUR LA DETERMINATION DE LOCALISATION DE DEFAUT EN CAS DE COURT-CIRCUIT LE LONG D'UNE SECTION D'ALIMENTATION D'ENERGIE A PLUSIEURS CONDUCTEURS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.09.2014 DE 102014217972**

(43) Veröffentlichungstag der Anmeldung:
**23.03.2016 Patentblatt 2016/12**

(73) Patentinhaber: **Siemens Mobility GmbH**
**81739 München (DE)**

(72) Erfinder:
• **Altmann, Martin**
**91054 Erlangen (DE)**
• **Bianchi, Roberto**
**91056 Erlangen (DE)**

(56) Entgegenhaltungen:
US-A- 5 839 093      US-A1- 2006 025 942
US-A1- 2009 150 099

• LAURENTIU NASTAC ET AL: "Advanced Fault Analysis Software System (or AFAS) for Distribution Power Systems", POWER SYMPOSIUM, 2007. NAPS '07. 39TH NORTH AMERICAN, IEEE, PI, 1. September 2007 (2007-09-01), Seiten 600-607, XP031190357, ISBN: 978-1-4244-1725-4

EP 2 998 750 B1

**Beschreibung**

Die Erfindung betrifft ein Verfahren und eine Anordnung für die Ermittlung eines Fehlerortes bei einem Kurzschluss entlang einer Energieversorgungsstrecke mit mehreren Leitern.

Eine Energieversorgungsstrecke kann im Sinne der Erfindung beispielsweise eine Bahnstromversorgung sein. Bei der Bahnstromversorgung kommen häufig einphasige Oberleitungssysteme zum Einsatz, deren elektrische Energie aus herkömmlichen dreiphasigen Versorgungsnetzen entnommen werden muss.

Ein bekanntes Verfahren zur Ermittlung eines Fehlerorts bei einem Kurzschluss in einem System aus verzweigten Kabeln ist in der US 2006/0025942 A1 beschrieben. Um zu ermitteln in welchem Kabelzweig ein Kurzschluss vorliegt, wird ein Vergleich mit einem gemessenen HF Impedanz-Phasen-Spektrum angestellt.

Aus dem Fachbuch "Fahrleitungen elektrischer Bahnen" von F. Kießling, R. Puschmann und A. Schmieder, 3. Auflage aus dem Jahr 2014 sind aus den Seiten 76 bis 85 verschiedene Anschlussmöglichkeiten der Bahnstromversorgung an ein dreiphasiges Versorgungsnetz bekannt. So kann bei einer so genannten Einphasenbahn die nötige Spannung jeweils für einzelne Abschnitte der Bahnstromversorgung abwechselnd aus einzelnen Außenleitern eines dreiphasigen Versorgungsnetzes entnommen werden (Bild 1.29 auf Seite 77). Weiterhin ist eine so genannte Zweispannungs-Bahnstromversorgung (Bild 1.30 auf Seite 78, Text Seite 78 ff) beschrieben, bei der Autotransformatoren eingesetzt werden.

Bei dem bekannten Autotransformatorsystem werden in einem Unterwerk der Bahnstromversorgung mittels Transformatoren aus einem dreiphasiges Versorgungsnetz für je einen Fahrleitungsabschnitt eine Fahrleitung, der sogenannte "positive Feeder", und ein entlang der Bahnstrecke isoliert mitgeführter Leiter, der sogenannte "negative Feeder", gespeist. An das Unterwerk ist die Schiene, die Erdpotential aufweist, angeschlossen. Am anderen Ende des Fahrleitungsabschnitts befindet sich ein Autotransformator, der mit den beiden Leitern und an seiner Mittelanzapfung mit der Schiene verbunden ist. Wird der Fahrleitungsabschnitt durch ein Triebfahrzeug befahren, so entnimmt das Triebfahrzeug einen ersten Speisestrom aus Richtung des Unterwerks und einen zweiten Speisestrom aus Richtung des Autotransformators. Die beiden Speiseströme sind gegeneinander um 180° phasenverschoben.

Autotransformatorsysteme werden zur Bahnstromversorgung eingesetzt, weil sich über weite Strecken die Belastungsströme der Fahrleitung halbieren und damit auch die entsprechenden Spannungsabfälle verringern. Dadurch können bei Autotransformatorsystemen in der Bahnstromversorgung die Abstände von Unterwerken an der Bahnstrecke erhöht werden, was Kosten einspart. Außerdem werden Störeinflüsse auf Fernmeldeleitungen verringert.

Bei vielen Bahn- und Stromnetzbetreibern gewinnt die schnelle Lokalisierung und Beseitigung von Fehlern, z.B. durch Kurzschlüsse, zunehmend an Wichtigkeit. So genannte Schutzrelais aller Hersteller unterstützen dabei mit der Funktion "Fehlerortung". Diese Funktionalität besteht in der Lokalisierung des Fehlers in einem Wechselspannungssystem anhand der gemessenen Fehlerreaktanz bzw. des Blindwiderstands. Die gemessene Fehlerreaktanz und Fehlerddistanz, die den Fehlerort angibt, werden vom Schutzrelay in Form einer elektronischen Information dem Betreiber bereitgestellt. Diese Information wird vom Betreiber benutzt, um das Wartungspersonal sofort an die richtige Fehlerstelle zu entsenden. Dies erspart Suchzeiten und erhöht somit die Verfügbarkeit der Infrastruktur; gleichzeitig werden Kosten gespart, da das Wartungspersonal effizienter arbeiten kann.

Die Fehlerortung basiert auf der Umrechnung der Fehlerreaktanz bzw. -impedanz in die Fehlerdistanz. Heutige Schutzrelais können die Reaktanz in Distanz nur dann umrechnen, wenn das Verhältnis der zwei Größen (abschnittweise) linear ist. Bei Systemen mit Booster-Transformatoren oder Autotransformatoren ist die Distanz-Reaktanz Kurve dagegen nicht mehr linear.

Insbesondere bei Verwendung eines Autotransformatorsystems entstehen durch die Einführung eines so genannten Negative Feeders eine zweite und eine dritte Distanz-Reaktanz Kurve. Es ergibt sich dabei das Problem, dass ein Fehler aufgrund unterschiedlicher Distanz-Reaktanz-Verläufe der drei Kurven mitunter mehrere mögliche Fehlerorte ergeben.

Um das Problem der Mehrdeutigkeit zu lösen, sind im Stand der Technik spezielle Steuerungskonzepte entwickelt worden.

Insbesondere werden die Autotransformatoren komplett aus dem Netz genommen, was beispielsweise in dem Zeitschriftenartikel "Protection of high-speed railway lines in Italy against faults" von E.Cinieri, G.Nurzia, A.Fumi, V.Salvatori und C.Spalvieri, erschienen in Elektrische Bahnen, Heft 1-2 2007, Kapitel 1 auf der Seite 82 beschrieben wird. Dadurch ergibt sich ein einseitig gespeistes, nicht vermaschtes Netz, womit eine lineare Reaktanzkurve gegeben ist. In diesem Netz ist dann möglich, durch eine automatische Wiederzuschaltung die Fehlerreaktanz erneut zu messen und diese einer eindeutigen Streckenlänge zuzuordnen. Diese Lösung hat drei Nachteile: Erstens ist die Rekonfiguration des Netzes zeitaufwändig, was die Verfügbarkeit des Netzes einschränkt. Zweitens können transiente Fehler nicht lokalisiert werden, da diese Fehler nach der Rekonfiguration bereits nicht mehr auftreten. Dies führt i.d.R. zu der Pflicht einer Streckeninspektion. Diese ist mit hohen Kosten und Personalaufwand verbunden. Ein dritter Nachteil ist die Notwendigkeit einer Wiederzuschaltung, was die Betriebsmittel weiter belastet.

Eine andere Lösung des Standes der Technik beruht auf dem Vergleich der Stromamplituden eines Fehlerstromes, wobei die Stromamplituden in der Mittenanzapfung der Autotransformatoren entlang der Strecke gemessen werden. Eine solche Lösung wird in dem Zeitschriftenartikel "Autotransformatorensystem für die Luino-Linie" von M. Aeberhard, E. Basler und F. Leu, erschienen in Elektrische Bahnen, Heft 6 2014, Kapitel 4.4.5 auf den Seiten 350 bis 351 vorgeschlagen. Dafür müssen die abgeschalteten Ströme in den Autotransformatorstationen aufgezeichnet werden. Meist sind dafür zusätzliche Geräte in der Autotransformator-Station und eine zentrale Auswertung notwendig. Aus dem Verhältnis der gemessenen Fehlerströme und erfahrungsbasierten Gewichtungsfaktoren wird der Fehlerort zwischen zwei Autotransformator-Stationen bestimmt. Für eine gleichbleibende Genauigkeit sind hierfür außerdem in den speisenden Unterwerken weitere Autotransformatoren bzw. eine feste Kopplung zwischen den zwei Phasen der Oberleitung und des negative Feeders notwendig.

Ferner ist aus dem Handbuch "SIPROTEC Digitaler Oberleitungsschutz für AC-Bahnstromversorgung 7ST6 V4.6", Dokumentennummer E50417-G1100-C251-A6, Ausgabedatum 09.11.2012, Seiten 156 bis 158 sowie 207 bis 208, ein Verfahren und eine Anordnung für die Ermittlung eines Fehlerortes bei einem Kurzschluss entlang einer Bahnstrecke mit einer Bahnstromversorgung bekannt. Dabei wird eine Fehlerreaktanz ermittelt und mindestens ein möglicher Fehlerort ausgegeben.

An die Erfindung stellt sich die technische Aufgabe, ein Verfahren für die Ermittlung eines Fehlerortes bei einem Kurzschluss entlang einer Energieversorgungsstrecke mit mehreren Leitern anzugeben, mit dem vergleichsweise einfach und schnell unter mehreren möglichen Fehlerorten der wahrscheinlichste Fehlerort ausgewählt wird.

Die Erfindung löst diese Aufgabe durch ein Verfahren gemäß Anspruch 1.

Dabei ist ein Fehlerort im Sinne der Erfindung ein Abschnitt der Energieversorgungsstrecke, also bei Einsatz des Verfahrens im Bereich der Bahnstromversorgung beispielsweise ein Punkt auf einer Oberleitung, an dem ein Kurzschluss gegenüber Erde oder gegenüber einem anderen spannungsführenden Leiter auftritt.

Weiterhin ist zu berücksichtigen, dass bei dem Verfahrensschritt des Vergleichs des ermittelten Widerstands mit jeweils einem vorbekannten Widerstandsverlauf für jeden Leiter unter Ermittlung mindestens eines möglichen Fehlerortes, der Begriff "Ermittlung" im einfachsten Fall für ein direktes Auslesen aus dem Widerstandsverlauf stehen kann. Wird beispielsweise im Widerstandsverlauf das Wertepaar (10 Ohm, 20 km) aufgeführt, so ergibt sich bei einem ermittelten Widerstand von 10 Ohm durch direktes Auslesen der mögliche Fehlerort bei 20 km; die Abweichung zwischen ermitteltem und ausgelesenem Widerstand ist null. In einem komplexeren Fall, wie er in einigen der nachfolgend beschriebenen Ausführungsformen im Zusammenhang mit einer Abweichungsmetrik ausführlich dargelegt wird, kann anstatt eines einfachen Auslesens aus dem Widerstandsverlauf eine Zuordnung zu einem Bereich des Widerstandsverlaufs erfolgen: beispielsweise wird ein Bereich von 9,7 bis 10,3 Ohm betrachtet, entsprechend ergeben sich Abweichungen zwischen dem ermittelten und dem aus dem Widerstandsverlauf entnommenen Widerstand. Diese Abweichungen können dann zusammen mit Abweichungen anderer Messwerte wie etwa des Stroms betrachtet und minimiert werden, um ein verbessertes Ergebnis des Verfahrens zu erzielen.

Das erfindungsgemäße Verfahren hat den Vorteil, dass auch bei mehreren möglichen Fehlerorten an einer Energieversorgungsstrecke der tatsächliche Fehlerort mit hoher Wahrscheinlichkeit bestimmt werden kann. Dies wird erreicht, indem anders als bei bekannten Verfahren nicht nur der Widerstand zur Feststellung des Fehlerortes erfasst wird, sondern auch der Fehlerstrom. Hierfür ist es erforderlich, dass entsprechende Verläufe von Widerstand, Fehlerstrom und ggf. weiterer Messwerte im Vorfeld bestimmt werden. Dies kann z.B. bei Inbetriebnahme einer Energieversorgungsstrecke wie z.B. einer Bahnstrecke unter Verwendung eines Netzberechnungsmodells erfolgen.

Ein solcher Widerstandsverlauf, ein solcher Fehlerstromverlauf und ggf. der Verlauf weiterer Messwerte entlang der Energieversorgungsstrecke kann im Vorfeld beispielsweise durch das in der bisher unveröffentlichten Patentanmeldung "Verfahren zum Orten eines Kurzschlusses in einem wenigstens einen Leitungsabschnitt umfassenden Stromnetz", Aktenzeichen des DPMA 10 2014 203 906.1, Erfinder: Roberto Bianchi, Anmelder: Siemens Aktiengesellschaft, dargelegte Verfahren ermittelt werden.

Erfindungsgemäß kann das Verfahren sowohl bei Gleichstromversorgung als auch bei Wechselstromversorgung einer Energieversorgungsstrecke eingesetzt werden. Bei einer Gleichstromversorgung wird ein Widerstandswert erfasst und ausgewertet, während bei einer Wechselstromversorgung ein Blindwiderstandswert erfasst und ausgewertet wird.

Die Fehlerortung kann dabei direkt beim ersten Abschalten der Energieversorgungsstrecke durch ein Schutzgerät erfolgen, wodurch mit Vorteil auch transiente Fehler verortet werden können.

Durch die Feststellung des Fehlerortes ist es nicht wie im Stand der Technik häufig praktiziert erforderlich, durch geschultes Personal eine Begehung der Strecke vornehmen zu lassen, um unter mehreren möglichen Fehlerorten den tatsächlichen Fehlerort zu entdecken. Dies spart Zeit und Kosten.

Ein weiterer Vorteil ist es, dass keine Wiederzuschaltung der Energieversorgungsstrecke für die Fehlerortung notwendig ist. Somit kann eine unnötige Belastung der Betriebsmittel vermieden werden. Außerdem erhöht eine Fehlerortung ohne Rekonfiguration der Energieversorgungsstrecke die Verfügbarkeit der Energieversorgungsstrecke.

In einer bevorzugten Ausführungsform des erfindungsgemäßen Verfahrens wird als Energieversorgungsstrecke eine Bahnstromversorgung mit einem Zweispannungssystem verwendet, das als Leiter eine Fahrleitung, einen entlang der Bahnstromversorgung isoliert mitgeführten Leiter und eine Schiene auf Erdpotential aufweist und es wird als Widerstand ein Blindwiderstand ermittelt. Der isoliert mitgeführte Leiter weist dabei i.d.R. eine zur Fahrleitung phasenverschobene Spannung auf. Ein Zweispannungssystem bzw. Autotransformatorsystem ist mit Vorteil besonders für den Einsatz des erfindungsgemäßen Verfahrens geeignet, weil sich hier jeweils für die Oberleitung, den negative Feeder und die Schiene drei nicht lineare Blindwiderstandsverläufe entlang der Bahnstrecke ergeben, so dass eine Zuordnung eines Fehlers zu einem bestimmten Fehlerort auf entweder der Oberleitung oder dem negative Feeder besonders erschwert ist.

In einer bevorzugten Ausführungsform des erfindungsgemäßen Verfahrens wird mittels der Messeinrichtung mindestens ein weiterer Messwert aus der folgenden Aufzählung von Messwerten erfasst: Gesamtstrom aus Fahrleitung und dem isoliert mitgeführten Leiter; Teilströme in der Fahrleitung, dem isoliert mitgeführten Leiter und der Schiene; Aufteilung der Teilströme auf die Fahrleitung, den isoliert mitgeführten Leiter und die Schiene; Spannungsunterschiede zwischen Fahrleitung, dem isoliert mitgeführten Leiter und Erde; Spannungsunterschied zwischen der Fahrleitung und dem isoliert mitgeführten Leiter. Weiterhin ist es auch möglich und sinnvoll, aus Spannung und Strom abgeleitete Werte wie z.B. Energie, Leistung, Strom- oder Spannungsintegral zu erfassen. Die Verwendung eines weiteren Messwerts ist von Vorteil, weil hierdurch die Erkennung des tatsächlichen Fehlerortes verbessert wird.

In einer bevorzugten Ausführungsform des erfindungsgemäßen Verfahrens werden jeweils für jeden weiteren Messwert folgende Schritte durchgeführt:

- Berechnung einer Messwertabweichung zwischen einem erwarteten Messwert und dem ermittelten Messwert für jeden möglichen Fehlerort, wobei der erwartete Messwert anhand je eines vorbekannten Messwertverlaufes für jeden Leiter ermittelt wird;
- Ermitteln des möglichen Fehlerorts mit der geringsten Messwertabweichung und Berücksichtigung dieses möglichen Fehlerortes bei der Festlegung des Fehlerortes.

Die Berücksichtigung eines weiteren Messwerts ist von Vorteil, weil hierdurch die Erkennung des tatsächlichen Fehlerortes verbessert wird.

In einer bevorzugten Ausführungsform des erfindungsgemäßen Verfahrens wird der festgelegte Fehlerort an ein Leitstellensystem, insbesondere ein Supervisory Control and Data Acquisition System, übermittelt. Dies ist ein Vorteil, weil mittels des Leitstellensystems automatisiert oder durch Bedienpersonal schnell und effizient auf den an dem erkannten Fehlerort liegenden Kurzschluss reagiert werden kann.

In einer bevorzugten Ausführungsform des erfindungsgemäßen Verfahrens wird zusätzlich derjenige Fehlerort mit der zweitgeringsten Abweichung und/oder Messwertabweichung an ein Leitstellensystem, insbesondere ein Supervisory Control and Data Acquisition System, übermittelt. Dies ist ein Vorteil, weil auf diese Weise der zweitwahrscheinlichste Fehlerort angegeben werden kann, so dass in dem Fall, dass der Fehler nicht am wahrscheinlichsten Fehlerfall auftrat, schnell und mit geringem Aufwand der zweitwahrscheinlichste Fehlerort überprüft werden kann.

In einer bevorzugten Ausführungsform des erfindungsgemäßen Verfahrens wird die Abweichung und/oder Messwertabweichung jeweils durch Differenzbildung berechnet. Dies ist von Vorteil, weil eine Differenzbildung ein einfaches Verfahren ist.

In einer bevorzugten Ausführungsform des erfindungsgemäßen Verfahrens wird die Abweichung und/oder Messwertabweichung jeweils durch Minimierung einer Abweichungsmetrik berechnet. Die Benutzung einer Abweichungsmetrik ist eine Verallgemeinerung des erfindungsgemäßen Ansatzes. Dabei können alle Parameter (z.B. Reaktanzen, Ströme, Spannungen) in einer beliebigen Form kombiniert und gewichtet werden. Es ist ein wesentlicher Vorteil dieser Ausführungsform, dass eine Abweisungsmetrik flexibler an die jeweiligen technischen Erfordernisse der jeweiligen Energieversorgungsstrecke anpassbar ist.

In einer bevorzugten Ausführungsform des erfindungsgemäßen Verfahrens ist die Abweichungsmetrik wie folgt definiert:

$$e = [(X_f - X_m)/X_{max}]^2 + [(I_f - I_m)/I_{max}]^2 ,$$

wobei

e die Abweichungsmetrik,
$X_f$ den anhand des Widerstandverlaufs ermittelten Widerstand an dem möglichen Fehlerort,
$I_f$ den theoretischen Fehlerstrom an dem möglichen Fehlerort,
$X_m$ den gemessenen Widerstand,
Im dem gemessenen Fehlerstrom,

$X_{max}$ den maximal im Widerstandverlauf erfassten Widerstand, und

$I_{max}$ den maximal im Fehlerstromverlauf erfassten Fehlerstrom angeben. Diese Abweichungsmetrik ist vorteilhaft, weil auf diese Weise eine relative Widerstandsabweichung und eine relative Stromabweichung gleich gewichtet werden. Beispielsweise kann unter Verwendung der Abweichungsmetrik eine größere Abweichung des Widerstands am möglichen Fehlerort zugelassen werden (diese Abweichung des Widerstands ist ohne Verwendung der Abweichungsmetrik durch eine einfache Ermittlung aus dem Widerstandsverlauf gleich null), so dass sich eine kleinere Stromabweichung am möglichen Fehlerort ergibt.

In einer bevorzugten Ausführungsform des erfindungsgemäßen Verfahrens erfolgt die Minimierung der Abweichungsmetrik jeweils mittels einer Optimierung mit einem linearen und/oder einem nicht-linearen Optimierungsverfahren. Beispiele für Optimierungsverfahren sind: Minimum mean square error (MMSE), Least squares (LSE), Maximum Likelihood.

Ferner ist eine Aufgabe der Erfindung, eine Anordnung für die Ermittlung eines Fehlerortes bei einem Kurzschluss entlang einer Energieversorgungsstrecke mit mehreren Leitern anzugeben, mit der vergleichsweise einfach und schnell unter mehreren möglichen Fehlerorten der wahrscheinlichste Fehlerort auswählbar ist.

Die Erfindung löst diese Aufgabe durch eine Anordnung gemäß Anspruch 11. Es ergeben sich sinngemäß die gleichen Vorteile wie eingangs für das erfindungsgemäße Verfahren erläutert.

Bevorzugte und vorteilhafte Ausführungsformen der erfindungsgemäßen Anordnung ergeben sich aus den abhängigen Ansprüchen 12 bis 15. Es ergeben sich dabei sinngemäß die gleichen Vorteile wie eingangs für das erfindungsgemäße Verfahren erläutert.

Im Folgenden wird die Erfindung zum besseren Verständnis anhand von Figuren erläutert.

Dabei zeigen in schematischer Darstellung

Figur 1    Ein Beispiel für in einem Autotransformatorsystem auftretenden Blindwiderstandverläufe und Fehlerstromverläufe entlang einer Bahnstrecke und

Figur 2    den Blindwiderstandverlauf und den Fehlerstromverlauf bei einem Kurzschluss zwischen einer Oberleitung und Erde gemäß Figur 1 und

Figur 3    den Blindwiderstandverlauf und den Fehlerstromverlauf bei einem Kurzschluss zwischen einem negative Feeder und Erde gemäß Figur 1 und

Figur 4    den Blindwiderstandverlauf und den Fehlerstromverlauf bei einem Kurzschluss zwischen Oberleitung und negative Feeder gemäß Figur 1 und

Figur 5    ein Beispiel für die Feststellung eines Fehlerortes bei einem Kurzschluss zwischen einer Oberleitung und Erde gemäß Figur 2 und

Figur 6    ein Beispiel für die Feststellung eines Fehlerortes bei einem Kurzschluss zwischen einem negative Feeder und Erde gemäß Figur 3 und

Figur 7    ein Beispiel für die Feststellung eines Fehlerortes bei einem Kurzschluss zwischen Oberleitung und negative Feeder gemäß Figur 4.

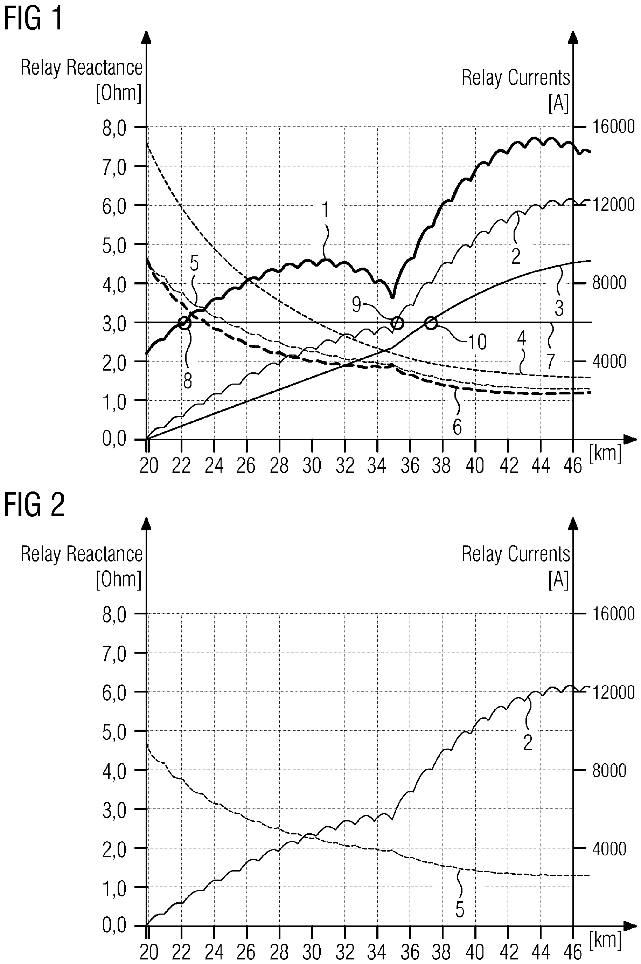

In der Figur 1 ist auf der linken Abszisse der Blindwiderstand in Ohm, auf der rechten Abszisse der Fehlerstrom im Ampere und auf der Ordinate die Distanz eines Einspeisepunkts zum Fehlerort in km, d.h. entlang der Bahnstromversorgung einer Bahnstrecke, aufgetragen.

Es sind für ein Autotransformatorsystem drei unterschiedliche Paare von Verläufen für Blindwiderstand und Fehlerstrom angegeben, nämlich

- erstens für einen Kurzschluss zwischen Oberleitung und Erde (Blindwiderstandverlauf 2, Fehlerstromverlauf 5),
- zweitens für einen Kurzschluss zwischen negative Feeder und Erde (Blindwiderstandverlauf 1, Fehlerstromverlauf 6) und
- drittens für einen Kurzschluss zwischen Oberleitung und negative Feeder (Blindwiderstandverlauf 3, Fehlerstromverlauf 4).

Wird nun z.B. bei einem Kurzschluss ein Blindwiderstand 7 von drei Ohm gemessen, so ergeben sich an den Schnittpunkten der Gerade für den Blindwiderstand 3 mit den vorbekannten Blindwiderstandverläufen 1,2,3 drei möglicher Fehlerorte 8,9,10. Eine eindeutige Zuordnung der Fehlerreaktanz zur Fehlerdistanz ist daher anhand des gemessenen Blindwiderstands nicht möglich.

Der mögliche Fehlerort 8 liegt auf dem negative Feeder bei 22,1 km. Der mögliche Fehlerort 9 liegt auf der Oberleitung bei 35,1 km. Der mögliche Fehlerort 10 liegt auf der Oberleitung bei 37 km und stellt einen möglichen Kurzschluss zum negative Feeder dar.

Zur besseren Übersichtlichkeit zeigt die Figur 2 den Blindwiderstandverlauf 2 und den Fehlerstromverlauf 5 bei einem Kurzschluss zwischen einer Oberleitung und Erde noch einmal separat.

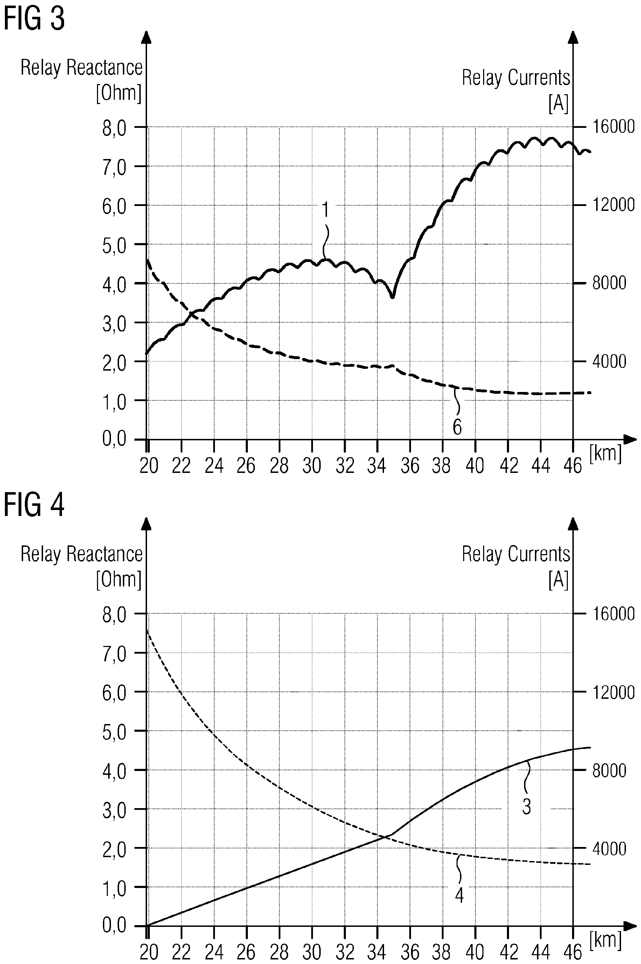

In gleicher Weise zeigt Figur 3 den Blindwiderstandverlauf 1 und den Fehlerstromverlauf 6 bei einem Kurzschluss zwischen einem negative Feeder und Erde gemäß Figur 1 noch einmal separat.

In gleicher Weise zeigt Figur 4 den Blindwiderstandverlauf 3 und den Fehlerstromverlauf 4 bei einem Kurzschluss zwischen Oberleitung und negative Feeder gemäß Figur 1 noch einmal separat.

Es werden dabei jeweils die gleichen Achsen sowie für gleiche Figurenelemente die gleichen Bezugzeichen wie in Figur 1 verwendet.

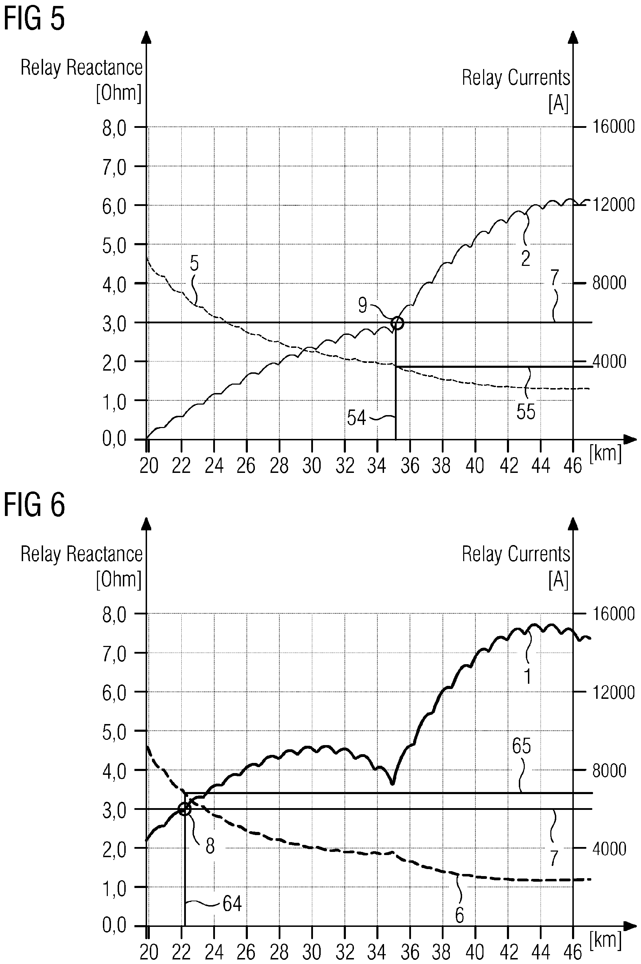

In der Figur 5 ist dargestellt, wie ein Fehlerstrom 55 an einem möglichen Fehlerort 9 anhand eines ermittelten Blindwiderstands 7 von drei Ohm, und des Blindwiderstandverlaufs 2 sowie des Fehlerstromverlaufs 5 gemäß Figur 2 graphisch bestimmbar ist. Am Schnittpunkt von ermitteltem Blindwiderstand 7 und vorbekanntem Blindwiderstandverlauf 2 liegt der mögliche Fehlerort 9. Die erste Gerade 54 zeigt einen möglichen Fehlerort bei 35,1km an. Am Schnittpunkt zwischen der ersten Gerade 54 und dem Fehlerstromverlauf 5 zeigt die zweite Gerade 55 einen erwarteten Fehlerstrom von 3720 A an. Der ermittelte Fehlerstrom (nicht dargestellt) beträgt in diesem Beispiel 3710 A und weicht somit nur 10 A vom erwarteten Fehlerstrom ab.

In der Figur 6 ist dargestellt, wie ein Fehlerstrom 65 an einem möglichen Fehlerort 8 anhand eines ermittelten Blindwiderstands 7 von drei Ohm, und des Blindwiderstandverlaufs 1 sowie des Fehlerstromverlaufs 6 gemäß Figur 3 graphisch bestimmbar ist. Am Schnittpunkt von ermitteltem Blindwiderstand 7 und vorbekanntem Blindwiderstandverlauf 1 liegt der mögliche Fehlerort 8. Die erste Gerade 64 zeigt einen möglichen Fehlerort bei 22,1km an. Am Schnittpunkt zwischen der ersten Gerade 64 und dem Fehlerstromverlauf 6 zeigt die zweite Gerade 65 einen erwarteten Fehlerstrom von 6500 A an. Der ermittelte Fehlerstrom (nicht dargestellt) beträgt in diesem Beispiel 3710 A und weicht somit 2790 A vom erwarteten Fehlerstrom ab.

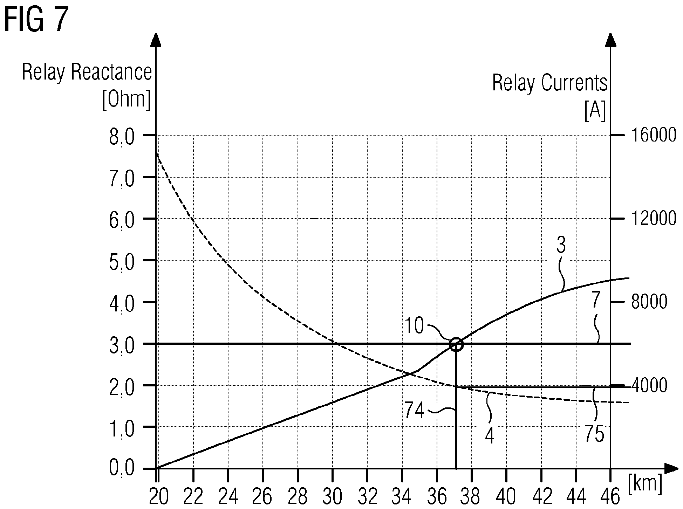

In der Figur 7 ist dargestellt, wie ein Fehlerstrom 75 an einem möglichen Fehlerort 10 anhand eines ermittelten Blindwiderstands 7 von drei Ohm, und des Blindwiderstandverlaufs 3 sowie des Fehlerstromverlaufs 4 gemäß Figur 4 graphisch bestimmbar ist. Am Schnittpunkt von ermitteltem Blindwiderstand 7 und vorbekanntem Blindwiderstandverlauf 3 liegt der mögliche Fehlerort 10. Die erste Gerade 74 zeigt einen möglichen Fehlerort bei 37 km an. Am Schnittpunkt zwischen der ersten Gerade 74 und dem Fehlerstromverlauf 4 zeigt die zweite Gerade 75 einen erwarteten Fehlerstrom von 3950 A an. Der ermittelte Fehlerstrom (nicht dargestellt) beträgt in diesem Beispiel 3710 A und weicht somit 240 A vom erwarteten Fehlerstrom ab.

Es ergibt sich für die drei möglichen Fehlerorte also jeweils eine Abweichung zwischen dem erwarteten Fehlerstrom und dem ermittelten Fehlerstrom, wobei in diesem Beispiel diese Abweichung für den möglichen Fehlerort 9 am geringsten ist. Daher ist der wahrscheinlichste Fehlerort ein Kurzschluss auf der Oberleitung bei 35,1 km. Der zweitwahrscheinlichste Fehlerort ist ein Kurzschluss zwischen der Oberleitung und dem negative Feeder bei 37 km.

**Patentansprüche**

1. Verfahren für die Ermittlung eines Fehlerortes (9) bei einem Kurzschluss entlang einer Energieversorgungsstrecke mit mehreren Leitern, umfassend die Schritte:

   - Ermittlung eines Widerstands (7) und eines Fehlerstroms an einer Messstelle der Energieversorgungsstrecke;
   - Vergleich des ermittelten Widerstands (7) mit jeweils einem vorbekannten Widerstandsverlauf (1,2,3) für jeden Leiter unter Ermittlung mindestens eines möglichen Fehlerortes (8,9,10);
   - Berechnung einer Abweichung zwischen einem erwarteten Fehlerstrom und dem ermittelten Fehlerstrom für jeden möglichen Fehlerort, wobei der erwartete Fehlerstrom anhand je eines vorbekannten Fehlerstromverlaufes (4,5,6) für jeden Leiter ermittelt wird;
   - Festlegung des Fehlerortes (9) als denjenigen Fehlerort mit der geringsten Abweichung.

2. Verfahren nach Anspruch 1,
   **dadurch gekennzeichnet, dass**
   als Energieversorgungsstrecke eine Bahnstromversorgung mit einem Zweispannungssystem verwendet wird, das als Leiter eine Fahrleitung, einen entlang der Bahnstromversorgung isoliert mitgeführten Leiter und eine Schiene auf Erdpotential aufweist und

dass als Widerstand ein Blindwiderstand ermittelt wird.

**3.** Verfahren nach Anspruch 2,
**dadurch gekennzeichnet, dass**
mindestens ein weiterer Messwert aus der folgenden Aufzählung von Messwerten erfasst wird: Gesamtstrom aus Fahrleitung und dem isoliert mitgeführten Leiter, Teilströme in der Fahrleitung, dem isoliert mitgeführten Leiter und der Schiene; Aufteilung der Teilströme auf die Fahrleitung, den isoliert mitgeführten Leiter und die Schiene; Spannungsunterschiede zwischen Fahrleitung, dem isoliert mitgeführten Leiter und Erde; Spannungsunterschied zwischen der Fahrleitung und dem isoliert mitgeführten Leiter.

**4.** Verfahren nach Anspruch 3,
**dadurch gekennzeichnet, dass**
jeweils für jeden weiteren Messwert folgende Schritte durchgeführt werden:

- Berechnung einer Messwertabweichung zwischen einem erwarteten Messwert und dem ermittelten Messwert für jeden möglichen Fehlerort (8,9,10), wobei der erwartete Messwert anhand je eines vorbekannten Messwertverlaufes für jeden Leiter ermittelt wird;
- Ermitteln des möglichen Fehlerorts mit der geringsten Messwertabweichung und Berücksichtigung dieses möglichen Fehlerortes bei der Festlegung des Fehlerortes.

**5.** Verfahren nach einem der vorhergehenden Ansprüche,
**dadurch gekennzeichnet, dass**
der festgelegte Fehlerort an ein Leitstellensystem, insbesondere ein Supervisory Control and Data Acquisition System, übermittelt wird.

**6.** Verfahren nach einem der vorhergehenden Ansprüche,
**dadurch gekennzeichnet, dass**
zusätzlich derjenige Fehlerort mit der zweitgeringsten Abweichung und/oder Messwertabweichung an ein Leitstellensystem, insbesondere ein Supervisory Control and Data Acquisition System, übermittelt wird.

**7.** Verfahren nach einem der vorhergehenden Ansprüche,
**dadurch gekennzeichnet, dass**
die Abweichung und/oder die Messwertabweichung jeweils durch Differenzbildung berechnet wird.

**8.** Verfahren nach einem der vorhergehenden Ansprüche,
**dadurch gekennzeichnet, dass**
die Abweichung und/oder die Messwertabweichung jeweils durch Minimierung einer Abweichungsmetrik berechnet wird.

**9.** Verfahren nach Anspruch 8,
**dadurch gekennzeichnet, dass**
die Abweichungsmetrik wie folgt definiert ist:

$$e = [(X_f - X_m)/X_{max}]^2 + [(I_f - I_m)/I_{max}]^2 ,$$

wobei

e die Abweichungsmetrik,
$X_f$ den anhand des Widerstandverlaufs ermittelten Widerstand an dem möglichen Fehlerort,
$I_f$ den theoretischen Fehlerstrom an dem möglichen Fehlerort,
$X_m$ den gemessenen Widerstand,
$I_m$ dem gemessenen Fehlerstrom,
$X_{max}$ den maximal im Widerstandverlauf erfassten Widerstand, und
$I_{max}$ den maximal im Fehlerstromverlauf erfassten Fehlerstrom angeben.

**10.** Verfahren nach Anspruch 8 oder 9,

**dadurch gekennzeichnet, dass**
die Minimierung der Abweichungsmetrik jeweils mittels einer Optimierung mit einem linearen und/oder einem nicht-linearen Optimierungsverfahren erfolgt.

11. Anordnung für die Ermittlung eines Fehlerortes (9) bei einem Kurzschluss entlang einer Energieversorgungsstrecke mit mehreren Leitern, mit
einer Messeinrichtung für das Ermitteln eines Widerstands (7) und eines Fehlerstroms an einer Messstelle der Energieversorgungsstrecke und
einer Auswerteeinrichtung, die ausgebildet ist,

- den ermittelten Widerstand (7) mit jeweils einem vorbekannten Widerstandsverlauf (1,2,3) für jeden Leiter unter Ermittlung mindestens eines möglichen Fehlerortes (8,9,10) zu vergleichen,
- eine Abweichung zwischen einem erwarteten Fehlerstrom und dem ermittelten Fehlerstrom für jeden möglichen Fehlerort (8,9,10) zu berechnen, wobei der erwartete Fehlerstrom anhand je eines vorbekannten Fehlerstromverlaufes (4,5,6) für jeden Leiter ermittelt wird;
- den Fehlerort (9) als denjenigen Fehlerort mit der geringsten Abweichung festzulegen.

12. Anordnung nach Anspruch 11,
**dadurch gekennzeichnet, dass**
die Energieversorgungsstrecke eine Bahnstromversorgung mit einem Zweispannungssystem aufweist, das als Leiter eine Fahrleitung, einen entlang der Bahnstromversorgung isoliert mitgeführten Leiter und eine Schiene auf Erdpotential aufweist und das die Messeinrichtung geeignet ist, als Widerstand einen Blindwiderstand zu ermitteln.

13. Anordnung nach Anspruch 11 oder 12,
**dadurch gekennzeichnet, dass**
die Auswerteeinrichtung geeignet ist, die Abweichung jeweils durch Minimierung einer Abweichungsmetrik zu berechnen.

14. Anordnung nach einem der Ansprüche 11 bis 13,
**dadurch gekennzeichnet, dass**
die Auswerteeinrichtung geeignet ist,
die Abweichungsmetrik wie folgt einzusetzen:

$$e \;=\; [\,(X_f - X_m)/X_{max}\,]^2 \;+\; [\,(I_f - I_m)/I_{max}\,]^2 \;,$$

wobei

$e$ die Abweichungsmetrik,
$X_f$ den anhand des Widerstandverlaufs ermittelten Widerstand an dem möglichen Fehlerort,
$I_f$ den theoretischen Fehlerstrom an dem möglichen Fehlerort,
$X_m$ den gemessenen Widerstand,
$I_m$ dem gemessenen Fehlerstrom,
$X_{max}$ den maximal im Widerstandverlauf erfassten Widerstand, und
$I_{max}$ den maximal im Fehlerstromverlauf erfassten Fehlerstrom angeben.

15. Anordnung nach einem der Ansprüche 11 bis 14,
**dadurch gekennzeichnet, dass**
die Auswerteeinrichtung geeignet ist,
die Minimierung der Abweichungsmetrik jeweils mittels einer Optimierung mit einem linearen und/oder einem nicht-linearen Optimierungsverfahren vorzunehmen.

**Claims**

1. Method for the determination of a fault location (9) in the event of a short circuit along an energy supply line with a plurality of conductors, comprising the steps:

- determining a resistance (7) and a fault current at a measuring point of the energy supply line;
- comparing the determined resistance (7) with an already known resistance curve (1,2,3) for each conductor in each case, with the determination of at least one possible fault location (8,9,10);
- calculating a deviation between an anticipated fault current and the determined fault current for each possible fault location, wherein the anticipated fault current is determined on the basis of an already known fault current curve (4,5,6) for each conductor;
- specifying a fault location (9) as the fault location with the lowest deviation.

**2.** Method according to claim 1,
**characterised in that**
a rail power supply with a dual-voltage system is used as energy supply line, which rail power supply has as conductor an overhead line, a conductor which is carried along the rail power supply in an isolated manner and a rail at earth potential, and
a reactance is determined as the resistance.

**3.** Method according to claim 2,
**characterised in that**
at least one further measurement value from the following list of measurement values is captured: total current from the overhead line and the conductor carried along in an isolated manner, partial currents in the overhead line, the conductor carried along in an isolated manner and the rail; breakdown of the partial currents between the overhead line, the conductor carried along in an isolated manner and the rail; voltage differences between overhead line, the conductor carried along in an isolated manner and earth; voltage difference between the overhead line and the conductor carried along in an isolated manner.

**4.** Method according to claim 3,
**characterised in that**
for each further measurement value, the following steps are performed in each case:

- calculating a measurement value deviation between an anticipated measurement value and the determined measurement value for each possible fault location (8,9,10), wherein the anticipated measurement value is determined on the basis of an already known fault current curve for each conductor;
- calculating the possible fault location with the lowest measurement value deviation and taking into consideration this possible fault location when specifying the fault location.

**5.** Method according to one of the preceding claims,
**characterised in that**
the specified fault location is transmitted to a control centre system, in particular a supervisory control and data acquisition system.

**6.** Method according to one of the preceding claims,
**characterised in that**
in addition, the fault location with the second-lowest deviation and/or measurement value deviation is transmitted to a control centre system, in particular a supervisory control and data acquisition system.

**7.** Method according to one of the preceding claims,
**characterised in that**
the deviation and/or the measurement value deviation is calculated by forming the difference in each case.

**8.** Method according to one of the preceding claims,
**characterised in that**
the deviation and/or the measurement value deviation is calculated by minimising a deviation metric in each case.

**9.** Method according to claim 8,
**characterised in that**
the deviation metric is defined as follows:

$$e = [(X_f - X_m)/X_{max}]^2 + [(I_f - I_m)/I_{max}]^2 ,$$

where

e indicates the deviation metric,
$X_f$ indicates the resistance determined at the possible fault location on the basis of the theoretical resistance curve,
$I_f$ indicates the theoretical fault current at the possible fault location,
$X_m$ indicates the measured resistance,
$I_m$ indicates the measured fault current,
$X_{max}$ indicates the maximum resistance captured in the resistance curve, and
$I_{max}$ indicates the maximum fault current captured in the fault current curve.

10. Method according to claim 8 or 9,
**characterised in that**
the minimisation of the deviation metric takes place in each case by means of an optimisation using a linear and/or non-linear optimisation method.

11. Arrangement for the determination of a fault location (9) in the event of a short circuit along an energy supply line with a plurality of conductors, with
a measurement device for determining a resistance (7) and a fault current at a measuring point of the energy supply line and
an evaluation device, which is embodied

- to compare the determined resistance (7) with an already known resistance curve (1,2,3) for each conductor in each case, with the determination of at least one possible fault location (8,9,10),
- to calculate a deviation between an anticipated fault current and the determined fault current for each possible fault location (8,9,10), wherein the anticipated fault current is determined on the basis of an already known fault current curve (4,5,6) for each conductor;
- to specify the fault location (9) as the fault location with the lowest deviation.

12. Arrangement according to claim 11,
**characterised in that**
the energy supply line has a rail power supply with a dual-voltage system, which has as conductor an overhead line, a conductor which is carried along the rail power supply in an isolated manner and a rail at earth potential, and the measurement device is suitable for determining a reactance as the resistance.

13. Arrangement according to claim 11 or 12,
**characterised in that**
the evaluation device is suitable for calculating the deviation by minimising a deviation metric in each case.

14. Arrangement according to one of claims 11 to 13,
**characterised in that**
the evaluation device is suitable for implementing the deviation metric as follows:

$$e = [(X_f - X_m)/X_{max}]^2 + [(I_f - I_m)/I_{max}]^2 ,$$

where

e indicates the deviation metric,
$X_f$ indicates the resistance determined at the possible fault location on the basis of the resistance curve,
$I_f$ indicates the theoretical fault current at the possible fault location,
$X_m$ indicates the measured resistance,
$I_m$ indicates the measured fault current,
$X_{max}$ indicates the maximum resistance captured in the resistance curve, and

$I_{max}$ indicates the maximum fault current captured in the fault current curve.

15. Arrangement according to one of claims 11 to 14,
**characterised in that**
the evaluation device is suitable for
carrying out the minimisation of the deviation metric by means of an optimisation using a linear and/or a non-linear optimisation method in each case.

**Revendications**

1. Procédé de détermination de l'emplacement (9) du défaut lors d'un court-circuit sur une section d'alimentation en énergie ayant plusieurs conducteurs, comprenant les stades :

   - détermination d'une résistance (7) et d'un courant de défaut en un point de mesure de la section d'alimentation en énergie ;
   - comparaison de la résistance (7) déterminée à respectivement une courbe (1, 2, 3) de résistance connue à l'avance pour chaque conducteur avec détermination d'au moins un emplacement (8, 9, 10) possible du défaut ;
   - calcul d'un écart entre un courant de défaut escompté et le courant de défaut déterminé pour chaque emplacement possible du défaut, le courant de défaut escompté étant déterminé pour chaque conducteur à l'aide d'une courbe (4, 5, 6) de courant de défaut connue à l'avance ;
   - situation de l'emplacement (9) du défaut comme l'emplacement de défaut ayant l'écart le plus petit.

2. Procédé suivant la revendication 1,
**caractérisé en ce que**
l'on utilise comme section d'alimentation en énergie une alimentation en courant de traction ayant un système à deux tensions, qui a comme conducteur une caténaire, un conducteur passant de manière isolée le long de l'alimentation en courant de traction et un rail au potentiel de terre et
**en ce que** l'on détermine comme résistance une réactance.

3. Procédé suivant la revendication 2,
**caractérisé en ce que**
l'on détecte au moins une autre valeur de mesure de l'énumération suivante de valeurs de mesure : courant total de la caténaire et du conducteur passant de manière isolée,
courants partiels dans la caténaire, le conducteur passant de manière isolée et le rail ; répartition des courants partiels sur la caténaire, le conducteur passant de manière isolée et le rail ; différence de tension entre la caténaire, le conducteur passant de manière isolée et la terre ; différence de tension entre la caténaire et le conducteur passant de manière isolée.

4. Procédé suivant la revendication 3,
**caractérisé en ce que**
l'on effectue, pour chaque autre valeur de mesure, les stades suivants :

   - calcul d'un écart entre une valeur de mesure escomptée et la valeur de mesure déterminée pour chaque emplacement (8, 9, 10) de défaut possible, la valeur de mesure escomptée étant déterminée pour chaque conducteur à l'aide d'une courbe de valeurs de mesure connues à l'avance ;
   - détermination de l'emplacement possible du défaut par l'écart de valeur le plus petit et prise en compte de cet emplacement possible du défaut pour la fixation de l'emplacement du défaut.

5. Procédé suivant l'une des revendications précédentes,
**caractérisé en ce que**
l'on transmet l'emplacement fixé du défaut à un système de conduite, notamment à un supervisory control and data acquisition system.

6. Procédé suivant l'une des revendications précédentes,
**caractérisé en ce que**
l'on transmet, en plus, l'emplacement du défaut ayant l'écart et/ou l'écart de valeurs de mesure le deuxième le plus petit à un système de conduite, notamment à un supervisory control and data acquisition system.

**7.** Procédé suivant l'une des revendications précédentes,
**caractérisé en ce que**
l'on calcul, l'écart et/ou l'écart de valeur de mesure, respectivement, par formation d'une différence.

**8.** Procédé suivant l'une des revendications précédentes,
**caractérisé en ce que** l'on calcule l'écart et/ou l'écart de valeur de mesure, respectivement, en minimisant une métrique d'écart.

**9.** Procédé suivant la revendication 8,
**caractérisé en ce que**
la métrique d'écart est définie de la manière suivant :

$$e = [(X_f - X_m)/X_{max}]^2 + [(I_f - I_m)/I_{max}]^2,$$

dans laquelle

e est la métrique d'écart,
$X_f$ est la résistance à l'emplacement possible du défaut déterminée à l'aide de la courbe de résistance,
$I_f$ est le courant théorique de défaut à l'emplacement possible du défaut,
$X_m$ est la résistance mesurée,
$I_m$ est le courant de défaut mesuré,
$X_{max}$ est la résistance détectée au maximum dans la courbe de résistance,
et
$I_{max}$ est le courant de défaut détecté au maximum dans la courbe de courant de défaut.

**10.** Procédé suivant la revendication 8 ou 9,
**caractérisé en ce que**
la minimisation de la métrique d'écart s'effectue, respectivement, au moyen d'une optimisation par un procédé d'optimisation linéaire et/ou par un procédé d'optimisation non linéaire.

**11.** Système de détermination de l'emplacement (9) d'un défaut lors d'un court-circuit sur une section d'alimentation en énergie ayant plusieurs conducteurs, comprenant
un dispositif de mesure pour déterminer une résistance (7) et un courant de défaut en un point de mesure de la section d'alimentation en énergie et
un dispositif d'exploitation, qui est constitué

- pour comparer la résistance (7) déterminée à, respectivement, une courbe (1, 2, 3) de résistance connue à l'avance pour chaque conducteur avec détermination d'au moins un emplacement (8, 9, 10) possible du défaut,
- pour calculer un écart entre un courant de défaut escompté et un courant de défaut déterminé pour chaque emplacement (8, 9, 10) possible du défaut, le courant de défaut escompté étant déterminé pour chaque conducteur à l'aide d'une courbe (4, 5, 6) de courant de défaut connu à l'avance ;
- pour fixer l'emplacement (9) du défaut comme l'emplacement du défaut ayant l'écart le plus petit.

**12.** Système suivant la revendication 11,
**caractérisé en ce que**
la section d'alimentation en énergie a une alimentation en courant de traction ayant un système à deux tensions, qui a comme conducteur une caténaire, un conducteur passant de manière isolée le long de l'alimentation en courant de traction et un rail au potentiel de terre, et **en ce que** le dispositif de mesure est propre à déterminer comme résistance une réactance.

**13.** Système suivant la revendication 11 ou 12,
**caractérisé en ce que**
le dispositif d'exploitation est propre à calculer l'écart, respectivement, en minimisant une métrique d'écart.

**14.** Système suivant l'une des revendications 11 à 13,
**caractérisé en ce que**

le dispositif d'exploitation est propre à établir la métrique d'écart de la manière suivant :

$$e = [(X_f - X_m)/X_{max}]^2 + [(I_f - I_m)/I_{max}]^2,$$

dans laquelle

e est la métrique d'écart,
$X_f$ est la résistance à l'emplacement possible du défaut déterminée à l'aide de la courbe de résistance,
$I_f$ est le courant théorique de défaut à l'emplacement possible du défaut,
$X_m$ est la résistance mesurée,
$I_m$ est le courant de défaut mesuré,
$X_{max}$ est la résistance détectée au maximum dans la courbe de résistance,
et
$I_{max}$ est le courant de défaut détecté au maximum dans la courbe de courant de défaut.

15. Système suivant l'une des revendications 11 à 14,
**caractérisé en ce que**
le dispositif d'exploitation est propre
à effectuer la minimisation de la métrique d'écart, respectivement, au moyen d'une optimisation par un procédé d'optimisation linéaire et/ou par un procédé d'optimisation non linéaire.

**FIG 1**

**FIG 2**

## FIG 3

Relay Reactance [Ohm]

Relay Currents [A]

## FIG 4

Relay Reactance [Ohm]

Relay Currents [A]

FIG 5

FIG 6

# FIG 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20060025942 A1

**In der Beschreibung aufgeführte Nicht-Patentliteratur**

- **F. KIEßLING ; R. PUSCHMANN ; A. SCHMIEDER.** Fahrleitungen elektrischer Bahnen. 2014, 76-85
- Protection of high-speed railway lines in Italy against faults. **E.CINIERI ; G.NURZIA ; A.FUMI ; V.SALVATORI ; C.SPALVIERI.** Elektrische Bahnen. 2007, 82
- Autotransformatorensystem für die Luino-Linie. **M. AEBERHARD ; E. BASLER ; F. LEU.** Elektrische Bahnen. 2014, 350-351
- SIPROTEC Digitaler Oberleitungsschutz für AC-Bahnstromversorgung 7ST6 V4.6. Dokumentennummer E50417-G1100-C251-A6. 11. September 2012, 156-158, 207-208
- **ROBERTO BIANCHI ; ANMELDER.** Verfahren zum Orten eines Kurzschlusses in einem wenigstens einen Leitungsabschnitt umfassenden Stromnetz. *Aktenzeichen des DPMA 10 2014 203 906.1*